# EUROPEAN PATENT APPLICATION

(11) **EP 4 780 160 A1**
(43) Date of publication of application: **22.07.2026**
(21) Application number: 24888797.8
(22) Date of filing: 07.11.2024
(51) Int. Cl.: H10D 8/60, H10D 62/10, H10D 62/80

(54) **SEMICONDUCTOR DEVICE**

(30) Priority: 09.11.2023 JP 2023191794
(71) Applicant: Shindengen Electric Manufacturing Co., Ltd., Tokyo 100-0004 (JP)
(72) Inventor: MAEYAMA, Yusuke, Asaka-shi Saitama 351-0015 (JP)
(74) Representative: Pes, Matteo
(86) International application number: PCT/JP2024/039707
(87) International publication number: WO 2025/100506

(57) **Abstract**

[MEANS FOR SOLVING THE PROBLEM] There is provided a semiconductor device (100) comprising: an N-type gallium oxide crystal substrate (200); an electrode portion (400) provided on an outer surface of the gallium oxide crystal substrate; a P-type oxide semiconductor portion (210) that is in contact with the electrode portion and is provided on an inner surface of the gallium oxide crystal substrate; a high-resistance layer portion (610) provided on the inner surface of the gallium oxide crystal substrate and on an outer surface of the P-type oxide semiconductor portion; and an electrode portion (300) provided on the outer surface of the gallium oxide crystal substrate and electrically connected to none of the electrode portion, the P-type oxide semiconductor, or the high-resistance layer portion.

## Description

### TECHNICAL FIELD

The present invention relates to a semiconductor device.

### BACKGROUND ART

Patent Document 1 discloses a "semiconductor device and a method for manufacturing the same."

### PRIOR ART DOCUMENTS

### PATENT DOCUMENTS

Patent Document 1: Japanese Patent Application No. 2015-20663

A semiconductor device using gallium oxide (Ga₂O₃), which has a large energy band gap, has attracted attention as a next-generation switching element capable of achieving high breakdown voltage, low loss, and high heat resistance, and is expected to be applied to power semiconductor devices such as inverters. FIG. 1 of Patent Document 1 schematically illustrates an example in which a heterojunction barrier layer is provided within a semiconductor device to enable higher breakdown voltage operation of the device and the like.

### SUMMARY OF THE INVENTION

In a first embodiment of the present invention, there is provided a semiconductor device comprising: an N-type gallium oxide crystal substrate; an electrode portion provided on an outer surface of the gallium oxide crystal substrate; a P-type oxide semiconductor portion that is in contact with the electrode portion and provided on an inner surface of the gallium oxide crystal substrate; a high-resistance layer portion provided on the inner surface of the gallium oxide crystal substrate and on an outer surface of the P-type oxide semiconductor portion; and an electrode portion provided on the outer surface of the gallium oxide crystal substrate and not electrically connected to any of the electrode portion, the P-type oxide semiconductor portion, or the high-resistance layer portion.

In a second embodiment of the present invention, there is provided a semiconductor device wherein the gallium oxide crystal substrate comprises a plurality of N-type gallium oxide layers having different average conductivities.

In a third embodiment of the present invention, there is provided a semiconductor device wherein the high-resistance layer portion is in contact with the entire outer surface of the P-type oxide semiconductor portion.

In a fourth embodiment of the present invention, there is provided a semiconductor device comprising a high-resistance layer portion provided on the inner surface of the gallium oxide crystal substrate and not in contact with the P-type oxide semiconductor portion.

In a fifth embodiment of the present invention, there is provided a semiconductor device comprising a P-type oxide semiconductor portion that is in contact with the electrode portion and is provided on the inner surface of the gallium oxide crystal substrate, and that is not in contact with the high-resistance layer portion.

It is to be noted that the foregoing summary of the invention does not enumerate all features of the present invention. Sub-combinations of these groups of features may also constitute an invention.

### BRIEF DESCRIPTION OF THE DRAWINGS

FIG. 1 shows an example of a cross-sectional view of a semiconductor device according to Embodiment 1 of the present invention.
FIG. 2 shows an example of a cross-sectional view of a semiconductor device according to Embodiment 2 of the present invention.
FIG. 3 shows an example of a cross-sectional view of a semiconductor device according to Embodiment 3 of the present invention.
FIG. 4 shows an example of a cross-sectional view of a semiconductor device according to Embodiment 4 of the present invention.
FIG. 5 shows an example of a cross-sectional view of a semiconductor device according to Embodiment 5 of the present invention.

### DESCRIPTION OF EMBODIMENTS

The present invention will be described below through embodiments of the invention; however, the following embodiments of the invention are not intended to limit the invention as set forth in the claims. Furthermore, not all combinations of features described in the embodiments of the invention are necessarily essential to the solution of the invention.

Furthermore, the semiconductor device of the present invention is assumed to have a size large enough to be visible to the naked eye. Accordingly, the electron waves, which play an important role in the semiconductor device, spread sufficiently within the semiconductor device. In particular, while various layers are provided within the semiconductor substrate, the electron waves are assumed to spread sufficiently even in such layers. Electrons are reflected at the inner lateral surface of the semiconductor substrate, i.e., the inner surface of the semiconductor substrate. The electron waves spread to the outer lateral surface of the semiconductor substrate, i.e., the outer surface of the semiconductor substrate.

It is to be noted that the drawings used in the following description are schematic in nature, and the dimensional relationships and ratios of the respective elements shown in the drawings do not necessarily correspond to actual values. Moreover, the dimensional relationships and ratios of the respective elements do not necessarily correspond to one another across different drawings.

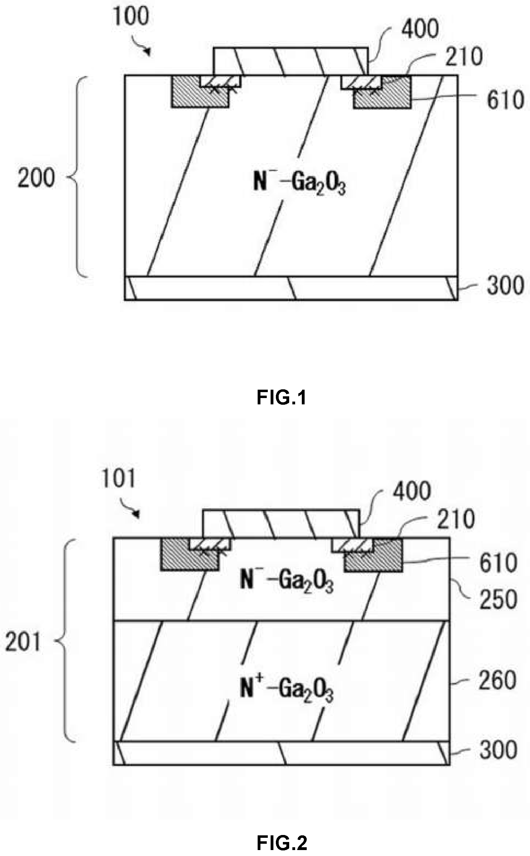

FIG. 1 shows an example of the configuration of a semiconductor device according to Embodiment 1 of the present invention. Semiconductor device 100 shown in FIG. 1 has electrode portion 300 and electrode portion 400 for making electrical connections with the outside. Electrode portion 300 and electrode portion 400 are provided on the outer surface of N-type gallium oxide crystal substrate 200.

Semiconductor device 100 comprises: N-type gallium oxide crystal substrate 200; electrode portion 400 provided on the outer surface of N-type gallium oxide crystal substrate 200; a P-type oxide semiconductor portion 210 that is in contact with electrode portion 400 and is provided on the inner surface of N-type gallium oxide crystal substrate 200; a high-resistance layer portion 610 provided on the inner surface of N-type gallium oxide crystal substrate 200 and on the outer surface of P-type oxide semiconductor portion 210; and electrode portion 300 provided on the outer surface of N-type gallium oxide crystal substrate 200 and electrically connected to none of electrode portion 400, P-type oxide semiconductor portion 210, or high-resistance layer portion 610.

Semiconductor device 100 corresponds to the semiconductor device in the first embodiment described in the Summary of the Invention. N-type gallium oxide crystal substrate 200 corresponds to the N-type gallium oxide crystal substrate in the first embodiment described in the Summary of the Invention. Electrode portion 400 corresponds to the electrode portion provided on the outer surface of the gallium oxide crystal substrate in the first embodiment described in the Summary of the Invention. P-type oxide semiconductor portion 210 corresponds to the P-type oxide semiconductor portion that is in contact with the electrode portion and is provided on the inner surface of the gallium oxide crystal substrate, as described in the first embodiment in the Summary of the Invention. High-resistance layer portion 610 corresponds to the high-resistance layer portion provided on the inner surface of the gallium oxide crystal substrate and on the outer surface of the P-type oxide semiconductor portion, as described in the first embodiment in the Summary of the Invention. Electrode portion 300 corresponds to the electrode portion provided on the outer surface of the gallium oxide crystal substrate and electrically connected to none of the electrode portion, the P-type oxide semiconductor portion, or the high-resistance layer portion, as described in the first embodiment in the Summary of the Invention.

The reason that N-type gallium oxide crystal substrate 200 is employed is that it is suitable for manufacturing, within a practical period of time, a gallium oxide wafer substrate of a sufficiently large size required for manufacturing semiconductor device 100. The crystal structure of N-type gallium oxide crystal substrate 200 is of the β-type.

N-type gallium oxide crystal substrate 200 of Embodiment 1 is manufactured by processing an N-type gallium oxide crystal substrate having a substantially circular wafer shape when viewed from the direction in which electrode portion 300 or electrode portion 400 is formed. The thickness of the substrate is approximately 0.6 mm. Several representative methods for manufacturing an N-type gallium oxide crystal substrate are known; however, detailed descriptions of such manufacturing methods are omitted herein. As one example, the approximate activated donor concentration of N-type gallium oxide crystal substrate 200 doped with silicon atoms is 5×10¹⁶ cm⁻³. As one example, the area of electrode portion 300 formed on a chip of N-type gallium oxide crystal substrate 200 diced from a wafer is 4×4 mm².

An N-type gallium oxide wafer substrate has a diameter of several inches or more, and layers having various electrical functions can be provided on an inner surface of the wafer substrate using conventional semiconductor manufacturing equipment.

The high-resistance layer portion may have a high-resistance layer in which any one of a nitrogen element, an iron element, or a magnesium element is present in the gallium oxide crystal substrate and functions as a P-type dopant.

Using the same principle as an ion implantation process used in ordinary semiconductor device manufacturing processes employing silicon wafers, ionized nitrogen atoms N are implanted into N-type gallium oxide crystal substrate 200. The implanted nitrogen atoms form high-resistance layer portion 610.

It is also possible to use iron atoms Fe or magnesium atoms Mg in place of nitrogen atoms N. As one example, high-resistance layer portion 610 has an extremely high resistance approaching that of an insulator, making accurate measurement of its resistance value difficult; however, the embodiments of the invention are not limited thereto.

Since gallium oxide is more brittle than other semiconductor materials, it may be understood that ion implantation into a gallium oxide crystal substrate is liable to produce associated crystal defects in various forms compared to other semiconductor materials. The distribution and behavior of the generated defects are not well understood. The symbol "×" shown in all of FIGS. 1 through 5 schematically represents such defects by analogy with the case of silicon.

Furthermore, while the dopant in Embodiment 1 is nitrogen, it may be understood that what happens to the defects generated by ion implantation upon heat treatment, which is generally performed to activate the dopant atoms after implantation, is also not well understood in detail.

There are types of gallium oxide, such as κ-type gallium oxide, in which the piezoelectric effect is prominently manifested. For this reason, it is difficult to predict how the stress due to heat generation from semiconductor device 100 during operation in addition to the residual stress will affect the electrical characteristics of semiconductor device 100.

In particular, when a gallium oxide substrate manufactured by a third party is processed to manufacture a semiconductor device, it is difficult to obtain information regarding the state of residual stress. Furthermore, when there is a high-temperature heat treatment process described below in addition to the ion implantation process, it becomes extremely difficult to predict the electrical characteristics of semiconductor device 100 to be ultimately manufactured.

The P-type oxide semiconductor portion may comprise an oxide constituted by any one of NiO-based materials, CuO-based materials, Cu₂O-based materials, or SnO-based materials, or a combination thereof.

Following the ion implantation process described above, a trench is formed in the N-type gallium oxide crystal substrate using the same principle as a trench formation process used in a silicon-wafer-based semiconductor device manufacturing process. The trench is filled with a P-type oxide semiconductor using the same principle as a trench-filling process used in an ordinary silicon-based semiconductor device manufacturing process, thereby forming P-type oxide semiconductor portion 210.

Specifically, the trench provided in N-type gallium oxide crystal substrate 200 is filled with a P-type oxide semiconductor by sputtering or CVD. The P-type oxide semiconductor portion may comprise an oxide constituted by any one of NiO-based materials, CuO-based materials, Cu₂O-based materials, or SnO-based materials, or a combination thereof.

As one example, the trench described above has a depth of several tens of nanometers to several micrometers. Regarding P-type oxide semiconductor portion 210, since its purpose is to relax the electric field at the peripheral portion of electrode portion 400, it is not necessarily required to set a specific design value for the activated acceptor concentration. Accordingly, in Embodiment 1 as well, semiconductor device 100 is manufactured without setting a particular design value therefor.

In the foregoing process, heat treatment at as high a temperature as appropriate is performed so that the various introduced atoms form appropriate chemical bonds with adjacent atoms and exhibit P-type or high-resistance electrical characteristics within the gallium oxide substrate. It goes without saying that the conditions are not limited to one set and naturally depend on the manufacturing equipment used.

It is needless to say that by forming the trench as described above, the electronic state at and near the surface of the trench differs from that in the interior of the crystal, which can thus affect device operation.

Furthermore, it can be readily inferred that by using the above-mentioned elements (Ni, Cu, Sn) to fill the trench, which differ from the constituent elements of the semiconductor substrate (Ga and O) having a recess formed by the trench, the electronic state may change significantly due to the emergence of misfit lattice structures and the like.

In particular, the energy band gap of gallium oxide is larger than that of silicon, silicon carbide, or gallium nitride-a characteristic not found in other semiconductor materials-making it easier for additional energy levels to arise within the energy band gap. The existence of such energy levels can exert unexpectedly large effects on device operation. For reference, the approximate energy band gap values for gallium oxide, silicon, silicon carbide, and gallium nitride are 4.9, 1.1, 3.3, and 3.4 eV, respectively.

Additionally, the following reasons make it difficult to provide P-type oxide semiconductor portion 210.

First, the use of the above-mentioned elements (Ni, Cu, Sn) in the manufacturing process may cause some form of contamination in the laboratory and on the production line.

Second, in the manufacture of semiconductor devices, the maintenance and management costs for keeping the manufacturing environment extremely clean in the laboratory and on the production line become enormous.

Third, the manufacturing equipment itself is extremely expensive in the first place.

As described above, there are various obstacles that must be considered in providing P-type oxide semiconductor portion 210 in addition to providing high-resistance layer portion 610, from the perspectives of the characteristic properties of gallium oxide, the ion implantation process-which can affect device operation in some manner through the generation of defects-and process design.

Electrode portion 300, electrode portion 400, and N-type gallium oxide crystal substrate 200 are connected through a process by which they can be chemically bonded. As such a process, sputtering is ordinarily employed. Depending on the process conditions of this sputtering step and the posttreatment process conditions, either a Schottky barrier or an ohmic contact may be formed between electrode portion 300 or electrode portion 400 and N-type gallium oxide crystal substrate 200. As one example, the thickness of electrode portion 300 and electrode portion 400 is each on the order of several hundred nanometers.

In Embodiment 1 of the present invention, a process is employed in which an ohmic contact is formed between electrode portion 300 and N-type gallium oxide crystal substrate 200. Titanium metal is used as the sputtering material.

Similarly, either a Schottky barrier or an ohmic contact may be formed between electrode portion 400 and N-type gallium oxide crystal substrate 200.

In Embodiment 1 of the present invention, a process is employed in which a Schottky barrier is formed between electrode portion 400 and N-type gallium oxide crystal substrate 200. Nickel metal is used as the sputtering material.

The operation of semiconductor device 100 is described below. As a result of the process described above, a Schottky barrier is formed between electrode portion 400 and N-type gallium oxide crystal substrate 200, and an ohmic contact is formed between electrode portion 300 and N-type gallium oxide crystal substrate 200; accordingly, semiconductor device 100 operates as a so-called Schottky barrier diode.

Semiconductor device 100 has electrode portion 300 and electrode portion 400, and there are three bias states depending on the potential difference between electrode portion 300 and electrode portion 400.

Specifically, with electrode portion 300 as the reference, there are three bias states: (1) forward bias, in which the potential of electrode portion 400 is higher than the potential of electrode portion 300; (2) zero bias, in which the potential of electrode portion 300 is equal to the potential of electrode portion 400; and (3) reverse bias, in which the potential of electrode portion 400 is lower than the potential of electrode portion 300.

When semiconductor device 100 is in the forward bias state or the reverse bias state, the same value of current flows through electrode portion 300 and electrode portion 400. Stated differently, when semiconductor device 100 is in the forward bias state or the reverse bias state, semiconductor device 100 has a size of sufficient magnitude to allow the same value of current to flow through electrode portion 300 and electrode portion 400.

Here, as one example of a problem to be solved, when semiconductor device 100 is in the reverse bias state, there is a user requirement to make the current flowing through electrode portion 300 and electrode portion 400 as small as possible. When a semiconductor device is used as a switching element, the reverse bias state corresponds to the switching element being in the off state, which makes it possible to reduce the standby power consumption of electronic equipment and the like in which it is used.

Embodiment 1 serves to improve the magnitude of the current flowing through electrode portion 300 and electrode portion 400 when semiconductor device 100 is in the reverse bias state.

In Embodiment 1, P-type oxide semiconductor portion 210 is provided inside N-type gallium oxide crystal substrate 200 so as to be in contact with the end portion of electrode portion 400, which serves as the anode electrode of the Schottky barrier diode.

Furthermore, high-resistance layer portion 610 is provided so as to be in contact with P-type oxide semiconductor portion 210. Since electric field lines can exist within high-resistance layer portion 610, when semiconductor device 100 enters the reverse bias state, electric field lines are present within high-resistance layer portion 610.

That is, the distribution of electric field lines within N-type gallium oxide crystal substrate 200 changes, and in regions within N-type gallium oxide crystal substrate 200 other than high-resistance layer portion 610, there can exist portions where the electric field intensity is reduced compared to a case where high-resistance layer portion 610 is absent.

Consequently, the electric field intensity at the interface between P-type oxide semiconductor portion 210 and N-type gallium oxide crystal substrate 200 is relaxed.

Since P-type oxide semiconductor portion 210 and N-type gallium oxide crystal substrate 200 have different combinations of constituent atoms, atomic-level consistency of atomic arrangement and the like is difficult to achieve at and near the interface between P-type oxide semiconductor portion 210 and N-type gallium oxide crystal substrate 200. Due to this, unintended energy levels within the energy band gap tend to arise easily.

Therefore, when an electric field exists at and near the interface between P-type oxide semiconductor portion 210 and N-type gallium oxide crystal substrate 200, so-called leakage current tends to flow easily through semiconductor device 100.

In Embodiment 1, the electric field intensity at the interface between P-type oxide semiconductor portion 210 and N-type gallium oxide crystal substrate 200 is relaxed as described above.

As a result, the drift current component flowing through the interface between P-type oxide semiconductor portion 210 and N-type gallium oxide crystal substrate 200 is reduced.

Furthermore, since the electric field intensity at the interface between electrode portion 400 and N-type gallium oxide crystal substrate 200 is also relaxed, the Schottky barrier is less prone to reduction, and the current flowing through electrode portion 400 is reduced.

In this manner, semiconductor device 100 of Embodiment 1 is characterized in that, by providing high-resistance layer portion 610, the values of the current flowing through electrode portion 300 and electrode portion 400 in the reverse bias state are reduced compared to a case where high-resistance layer portion 610 is not provided.

The gallium oxide crystal substrate may comprise a plurality of N-type gallium oxide layers having different average conductivities. This makes it possible, for example, to more easily solve not only the problem of reducing leakage current in a semiconductor device in the reverse bias state, but also the problem of increasing the forward current in the semiconductor device in the forward bias state.

FIG. 2 shows an example of the configuration of semiconductor device 101 according to Embodiment 2 of the present invention. As shown in FIG. 2, N⁻ gallium oxide layer 250 is provided so that the average conductivity of the N-type gallium oxide layer in contact with electrode portion 400 is made lower, and N⁺ gallium oxide layer 260 is provided so that the average conductivity of the N-type gallium oxide layer in contact with electrode portion 300 is made higher. As one example, the approximate activated donor concentrations of N⁻ gallium oxide layer 250 and N⁺ gallium oxide layer 260 are 2×10¹⁶ cm⁻³ and 1×10¹⁶ cm⁻³, respectively. As other examples, the combination of approximate activated donor concentrations of N⁻ gallium oxide layer 250 and N⁺ gallium oxide layer 260 may differ by orders of magnitude, such as 1×10¹⁶ cm⁻³ and 5×10¹⁸ cm⁻³, or 5×10¹⁵ cm⁻³ and 1×10¹⁹ cm⁻³.

Semiconductor device 101 corresponds to the semiconductor device in the second embodiment described in the Summary of the Invention. N-type gallium oxide crystal substrate 201 corresponds to the gallium oxide crystal substrate comprising a plurality of N-type gallium oxide layers having different average conductivities, as described in the second embodiment in the Summary of the Invention. N⁻ gallium oxide layer 250 corresponds to one of the plurality of N-type gallium oxide layers having different average conductivities, as described in the second embodiment in the Summary of the Invention. N⁺ gallium oxide layer 260 corresponds to one of the plurality of N-type gallium oxide layers having different average conductivities, as described in the second embodiment in the Summary of the Invention.

Semiconductor device 101 shown in FIG. 2 differs from semiconductor device 100 according to Embodiment 1 in that N-type gallium oxide crystal substrate 201 comprises a plurality of N-type gallium oxide layers having different average conductivities.

This difference makes it easier to change the internal electric field distribution of N-type gallium oxide crystal substrate 201, and therefore, compared to Embodiment 1, in addition to the characteristic in which the values of the current flowing through electrode portion 300 and electrode portion 400 are reduced compared to a case where high-resistance layer portion 610 is not provided, it becomes easier to design the reverse bias conditions under which semiconductor device 101 undergoes a so-called avalanche phenomenon. When the avalanche phenomenon occurs, an extremely large current flows through semiconductor device 101.

Furthermore, it becomes easier to make the thickness of the crystal substrate appropriate, making it easier to manufacture N-type gallium oxide crystal substrate 201 at an appropriate manufacturing cost. This is because the thickness of N⁻ gallium oxide layer 250 need only be sufficient for the so-called depletion layer to extend in accordance with the bias value when semiconductor device 101 is in a predetermined reverse bias state from the zero bias state.

Furthermore, it becomes easier to reduce conduction loss of the semiconductor device 101 in a forward bias state. This is because the N⁺ gallium oxide layer has a high average conductivity, thereby reducing the potential difference across that layer and making it easier to reduce conduction loss when the semiconductor device 101 is in the forward bias state.

The semiconductor device may be one in which the high-resistance layer portion is in contact with the entire outer surface of the P-type oxide semiconductor portion.

As one example, this may serve as a means for reducing only the leakage current value of the semiconductor device in the reverse bias state to the greatest extent possible, among the characteristics of the semiconductor device.

It should be noted that even though the high-resistance layer portion is in contact with the entire outer surface, since the high-resistance layer portion is provided on the inner surface of the gallium oxide crystal substrate, the high-resistance layer portion cannot be provided on the contact surface between the P-type oxide semiconductor portion and the inner surface of the gallium oxide crystal substrate. Therefore, the high-resistance layer portion does not completely enclose the P-type oxide semiconductor portion.

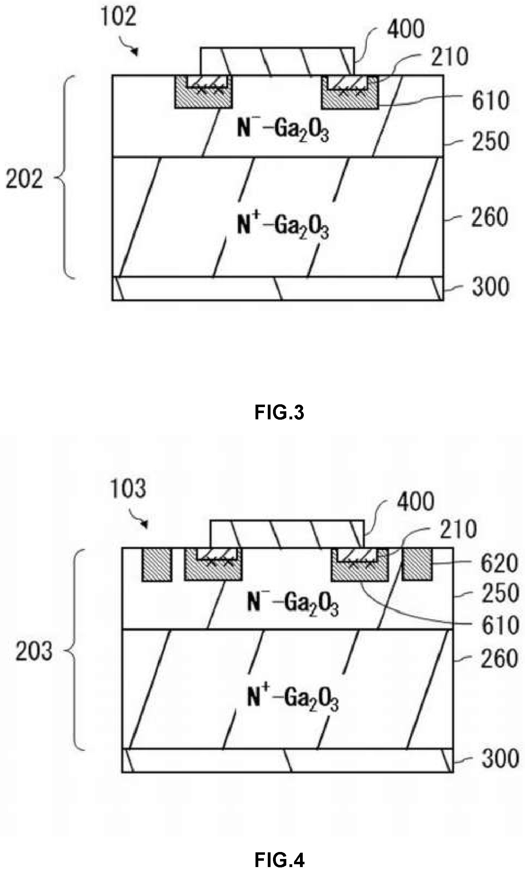

FIG. 3 shows an example of the configuration of semiconductor device 102 according to Embodiment 3 of the present invention.

Semiconductor device 102 corresponds to the semiconductor device in the third embodiment described in the Summary of the Invention. P-type oxide semiconductor portion 210 shown in FIG. 3 corresponds to the P-type oxide semiconductor portion in the third embodiment described in the Summary of the Invention. High-resistance layer portion 610 shown in FIG. 3 corresponds to the high-resistance layer portion that is in contact with the entire outer surface of the P-type oxide semiconductor portion, as described in the third embodiment in the Summary of the Invention.

Semiconductor device 102 shown in FIG. 3 differs from semiconductor devices 100 and 101 according to Embodiments 1 and 2 in that high-resistance layer portion 610 is in contact with the entire outer surface of P-type oxide semiconductor portion 210. That is, in semiconductor device 102, it may also be said that high-resistance layer portion 610, located within N-type gallium oxide crystal substrate 202, is in contact with and completely covers the outer surface of P-type oxide semiconductor portion 210.

Due to this difference, the volume of high-resistance layer portion 610 is larger compared to Embodiments 1 and 2, and therefore the volume of the depletion layer when semiconductor device 102 is in the reverse bias state is increased. As a result, compared to Embodiments 1 and 2, the electric field intensity in regions other than high-resistance layer portion 610 is reduced, making it easier to further reduce the current value when semiconductor device 100 is in the reverse bias state.

The semiconductor device may comprise one or more high-resistance layer portions provided on the inner surface of the gallium oxide crystal substrate and not in contact with the P-type oxide semiconductor portion. As one example, this may serve as a means for making the value of the so-called breakdown voltage as large as possible, in addition to improving the leakage current of the semiconductor device in the reverse bias state.

FIG. 4 shows an example of the configuration of semiconductor device 103 according to Embodiment 4 of the present invention.

Semiconductor device 103 corresponds to the semiconductor device in the fourth embodiment described in the Summary of the Invention. N-type gallium oxide crystal substrate 203 shown in FIG. 4 corresponds to the gallium oxide crystal substrate in the fourth embodiment described in the Summary of the Invention. P-type oxide semiconductor portion 210 shown in FIG. 4 corresponds to the P-type oxide semiconductor portion in the fourth embodiment described in the Summary of the Invention. High-resistance layer portion 620 shown in FIG. 4 corresponds to the high-resistance layer portion provided on the inner surface of the gallium oxide crystal substrate and not in contact with the P-type oxide semiconductor portion, as described in the fourth embodiment in the Summary of the Invention.

Semiconductor device 103 shown in FIG. 4 differs from semiconductor device 102 according to Embodiment 3 in that it has high-resistance layer portion 620 provided on the inner surface of the gallium oxide crystal substrate and not in contact with the P-type oxide semiconductor portion.

Due to this difference, compared to Embodiment 3, the volume of high-resistance layer portions in contact with the inner surface of the gallium oxide crystal substrate is increased by the volume of high-resistance layer portion 620, and therefore the volume of the depletion layer when semiconductor device 103 is in the reverse bias state is increased. Accordingly, the electric field intensity within the gallium oxide crystal substrate in regions other than high-resistance layer portion 610 is reduced compared to Embodiment 3, making it easier to further suppress the current when semiconductor device 103 is in the reverse bias state.

In Embodiment 4, high-resistance layer portion 620 is provided at a position farther from electrode portion 400 compared to high-resistance layer portion 610. It is also possible to provide high-resistance layer portion 620 so as to be in contact with electrode portion 400.

In this case, due to the relationship with P-type oxide semiconductor portion 210 and high-resistance layer portion 610, which are other regions, the distribution of the depletion layer when semiconductor device 103 is in the reverse bias state changes, and it is possible to further reduce the electric field intensity at and near the interface between electrode portion 400 and N-type gallium oxide substrate 203 compared to Embodiment 3.

That is, suppression of the reduction of the Schottky barrier is further enhanced, making it easier to further reduce the current value when semiconductor device 103 is in the reverse bias state. Furthermore, since the degree of design freedom is increased, by further reducing the electric field intensity at and near the interface between electrode portion 400 and N-type gallium oxide substrate 203 in the reverse bias state, it is possible to easily achieve a larger so-called breakdown voltage for semiconductor device 103 compared to any one of Embodiments 1 through 3.

On the other hand, if high-resistance layer portion 620 is provided so as to be in contact with electrode portion 400, the area of electrode portion 400 functioning as a Schottky barrier is reduced compared to Embodiment 3, which may result in a reduction of the current even in the forward bias state. For this reason, how high-resistance layer portion 620 is to be provided is closely related to the characteristic design in both the forward and reverse directions. Furthermore, when there are a plurality of high-resistance layer portions 620, the degree of design freedom is greater compared to when there is a single high-resistance layer portion 620, making it possible to significantly improve the electrical characteristics of semiconductor device 100 to meet user requirements compared to when there is only one high-resistance layer portion 620.

The semiconductor device may comprise one or more P-type oxide semiconductor portions that are in contact with the electrode portion and are provided on the inner surface of the gallium oxide crystal substrate, and that are not in contact with the high-resistance layer portion. As one example, this may serve as a means for making the value of the forward current as large as possible, in addition to improving the leakage current of the semiconductor device in the reverse bias state.

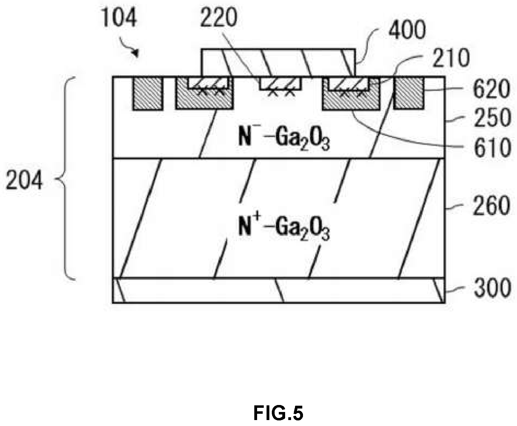

FIG. 5 shows an example of the configuration of semiconductor device 104 according to Embodiment 5 of the present invention.

Semiconductor device 104 corresponds to the semiconductor device in the fifth embodiment described in the Summary of the Invention. N-type gallium oxide crystal substrate 204 shown in FIG. 5 corresponds to the gallium oxide crystal substrate in the fifth embodiment described in the Summary of the Invention. P-type oxide semiconductor portion 220 shown in FIG. 5 corresponds to the P-type oxide semiconductor portion that is in contact with the electrode portion and is provided on the inner surface of the gallium oxide crystal substrate, and that is not in contact with the high-resistance layer portion, as described in the fifth embodiment in the Summary of the Invention. High-resistance layer portion 610 shown in FIG. 5 corresponds to the high-resistance layer portion in the fifth embodiment described in the Summary of the Invention. High-resistance layer portion 620 shown in FIG. 5 corresponds to the high-resistance layer portion in the fifth embodiment described in the Summary of the Invention.

Semiconductor device 104 shown in FIG. 5 differs from semiconductor device 103 according to Embodiment 4 in that it comprises P-type oxide semiconductor 220 that is in contact with electrode portion 400 and is provided on the inner surface of N-type gallium oxide crystal substrate 204, and that is not in contact with high-resistance layer portion 610.

Due to this difference, a PN diode is additionally provided within the semiconductor device, and while retaining to a certain extent the characteristic of suppressed current in the reverse bias state as in Embodiment 4, the current value of semiconductor device 104 in the forward bias state can be increased within a certain range of bias states compared to Embodiment 4.

It is also possible to provide a plurality of P-type oxide semiconductors 220. In that case, the distribution of the depletion layer when semiconductor device 104 is in the reverse bias state can change depending on the number, size, and arrangement of P-type oxide semiconductors 220, making it possible to further reduce the current value of semiconductor device 104 in the reverse bias state compared to when there is only one P-type oxide semiconductor 220. Since the degree of design freedom increases compared to when there is only one P-type oxide semiconductor 220, there is an aspect where the difficulty of design also increases. As the number of P-type oxide semiconductors 220 increases, the number of combinations increases enormously, and accordingly the difficulty of design becomes extremely high.

### (Supplementary Note 1)

A semiconductor device comprising:
an N-type gallium oxide crystal substrate;
an electrode portion provided on an outer surface of the gallium oxide crystal substrate;
a P-type oxide semiconductor portion that is in contact with the electrode portion and is provided on an inner surface of the gallium oxide crystal substrate;
a high-resistance layer portion provided on the inner surface of the gallium oxide crystal substrate and on an outer surface of the P-type oxide semiconductor portion; and
an electrode portion provided on the outer surface of the gallium oxide crystal substrate and electrically connected to none of the electrode portion, the P-type oxide semiconductor, or the high-resistance layer portion.

### (Supplementary Note 2)

The semiconductor device according to Supplementary Note 1, wherein the high-resistance layer portion has a high-resistance layer in which any one of a nitrogen element, an iron element, or a magnesium element is present in the gallium oxide crystal substrate and functions as a P-type dopant.

### (Supplementary Note 3)

The semiconductor device according to Supplementary Note 1, wherein the P-type oxide semiconductor portion comprises an oxide constituted by any one of NiO-based materials, CuO-based materials, Cu₂O-based materials, or SnO-based materials, or a combination thereof.

### (Supplementary Note 4)

The semiconductor device according to Supplementary Note 1, wherein the gallium oxide crystal substrate comprises a plurality of N-type gallium oxide layers having different average conductivities.

### (Supplementary Note 5)

The semiconductor device according to Supplementary Note 1, wherein the high-resistance layer portion is in contact with the entire outer surface of the P-type oxide semiconductor portion.

### (Supplementary Note 6)

The semiconductor device according to Supplementary Note 1, comprising one or more high-resistance layer portions provided on the inner surface of the gallium oxide crystal substrate and not in contact with the P-type oxide semiconductor portion.

### (Supplementary Note 7)

The semiconductor device according to any one of Supplementary Notes 1 through 6, comprising one or more P-type oxide semiconductor portions that are in contact with the electrode portion and are provided on the inner surface of the gallium oxide crystal substrate, and that are not in contact with the high-resistance layer portion.

### (Supplementary Note 8)

The semiconductor device according to any one of Supplementary Notes 3 through 7, wherein the high-resistance layer portion has a high-resistance layer in which any one of a nitrogen element, an iron element, or a magnesium element is present in the gallium oxide crystal substrate and functions as a P-type dopant.

### (Supplementary Note 9)

The semiconductor device according to any one of Supplementary Notes 2, 4, 5, 6, 7, and 8, wherein the P-type oxide semiconductor portion comprises an oxide constituted by any one of NiO-based materials, CuO-based materials, Cu₂O-based materials, or SnO-based materials, or a combination thereof.

### (Supplementary Note 10)

The semiconductor device according to any one of Supplementary Notes 2, 3, 5, 6, 7, 8, and 9, wherein the gallium oxide crystal substrate comprises a plurality of N-type gallium oxide layers having different average conductivities.

### (Supplementary Note 11)

The semiconductor device according to any one of Supplementary Notes 2, 3, 4, 6, 7, 8, 9, and 10, wherein the high-resistance layer portion is in contact with the entire outer surface of the P-type oxide semiconductor portion.

### (Supplementary Note 12)

The semiconductor device according to any one of Supplementary Notes 2, 3, 4, 5, 7, 8, 9, 10, and 11, comprising a high-resistance layer portion provided on the inner surface of the gallium oxide crystal substrate and not in contact with the P-type oxide semiconductor portion.

### (Supplementary Note 13)

The semiconductor device according to any one of Supplementary Notes 8 through 12, comprising a P-type oxide semiconductor portion that is in contact with the electrode portion and is provided on the inner surface of the gallium oxide crystal substrate, and that is not in contact with the high-resistance layer portion.

As described above, the present invention has been explained using Embodiments 1 through 5; however, the technical scope of the present invention is not limited to the scope described in the forms of the above embodiments. It will be apparent to a person skilled in the art that various modifications or improvements may be added to the content of the above embodiments. It is apparent from the description of the claims that such modified or improved forms may also be included within the technical scope of the present invention.

It should be noted that the order of the devices, processes, or operations of devices shown in the claims, specification, and drawings is not specifically described as "before," "prior to," or the like, and may be implemented in any order, unless the output of a preceding process is used in a subsequent process. Even if the description in the claims, specification, and operation of devices and the like uses terms such as "first" and "next," it does not mean that implementation in that order is essential.

### DESCRIPTION OF REFERENCE NUMERALS

- 100: semiconductor device
- 101: semiconductor device
- 102: semiconductor device
- 103: semiconductor device
- 104: semiconductor device
- 200: N-type gallium oxide crystal substrate
- 201: N-type gallium oxide crystal substrate
- 202: N-type gallium oxide crystal substrate
- 203: N-type gallium oxide crystal substrate
- 204: N-type gallium oxide crystal substrate
- 210: P-type oxide semiconductor portion
- 250: N⁻ gallium oxide layer
- 260: N⁺ gallium oxide layer
- 300: electrode portion
- 400: electrode portion
- 610: high-resistance layer portion
- 620: high-resistance layer portion.

## Claims

1. A semiconductor device comprising:
an N-type gallium oxide crystal substrate;
an electrode portion provided on an outer surface of the gallium oxide crystal substrate;
a P-type oxide semiconductor portion that is in contact with the electrode portion and is provided on an inner surface of the gallium oxide crystal substrate;
a high-resistance layer portion provided on the inner surface of the gallium oxide crystal substrate and on an outer surface of the P-type oxide semiconductor portion; and
an electrode portion provided on the outer surface of the gallium oxide crystal substrate and electrically connected to none of the electrode portion, the P-type oxide semiconductor, or the high-resistance layer portion.

2. The semiconductor device according to Claim 1, wherein the high-resistance layer portion has a high-resistance layer in which any one of a nitrogen element, an iron element, or a magnesium element is present in the gallium oxide crystal substrate and functions as a P-type dopant.

3. The semiconductor device according to Claim 1, wherein the P-type oxide semiconductor portion comprises an oxide constituted by any one of NiO-based materials, CuO-based materials, Cu₂O-based materials, or SnO-based materials, or a combination thereof.

4. The semiconductor device according to Claim 1, wherein the gallium oxide crystal substrate comprises a plurality of N-type gallium oxide layers having different average conductivities.

5. The semiconductor device according to Claim 1, wherein the high-resistance layer portion is in contact with the entire outer surface of the P-type oxide semiconductor portion.

6. The semiconductor device according to Claim 1, comprising a high-resistance layer portion provided on the inner surface of the gallium oxide crystal substrate and not in contact with the P-type oxide semiconductor portion.

7. The semiconductor device according to any one of Claims 1 through 6, comprising a P-type oxide semiconductor portion that is in contact with the electrode portion and is provided on the inner surface of the gallium oxide crystal substrate, and that is not in contact with the high-resistance layer portion.

8. The semiconductor device according to any one of Claims 3 through 7, wherein the high-resistance layer portion has a high-resistance layer in which any one of a nitrogen element, an iron element, or a magnesium element is present in the gallium oxide crystal substrate and functions as a P-type dopant.

9. The semiconductor device according to any one of Claims 2, 4, 5, 6, 7, and 8, wherein the P-type oxide semiconductor portion comprises an oxide constituted by any one of NiO-based materials, CuO-based materials, Cu₂O-based materials, or SnO-based materials, or a combination thereof.

10. The semiconductor device according to any one of Claims 2, 3, 5, 6, 7, 8, and 9, wherein the gallium oxide crystal substrate comprises a plurality of N-type gallium oxide layers having different average conductivities.

11. The semiconductor device according to any one of Claims 2, 3, 4, 6, 7, 8, 9, and 10, wherein the high-resistance layer portion is in contact with the entire outer surface of the P-type oxide semiconductor portion.

12. The semiconductor device according to any one of Claims 2, 3, 4, 5, 7, 8, 9, 10, and 11, comprising a high-resistance layer portion provided on the inner surface of the gallium oxide crystal substrate and not in contact with the P-type oxide semiconductor portion.

13. The semiconductor device according to any one of Claims 8 through 12, comprising a P-type oxide semiconductor portion that is in contact with the electrode portion and is provided on the inner surface of the gallium oxide crystal substrate, and that is not in contact with the high-resistance layer portion.
